# EUROPEAN PATENT APPLICATION

(11) **EP 4 822 991 A2**
(43) Date of publication of application: **14.10.2026**
(21) Application number: 26193026.7
(22) Date of filing: 15.06.2023
(51) Int. Cl.: H03K 17/16

(54) **DRIVING A POWER TRANSISTOR**

(62) Document number(s) of the earlier application(s) in accordance with Art. 76 EPC: 23179645.9 / 4 478 613
(71) Applicant: Infineon Technologies Austria AG, 9500 Villach (AT)
(72) Inventor: VITRENKO, Oleg, Villach (AT)
(74) Representative: Elkington and Fife LLP

(57) **Abstract**

A driver circuit is provided for driving a control terminal of a power transistor. The driver circuit includes a final driver stage with two switching elements. These two switching elements are coupled in series through an output node, which is configured to be coupled to the control terminal of the power transistor. Control logic of the driver circuit is configured to control the switching of the two switching elements so that at most one of the two switching elements is ON at any time. The control logic is configured to receive a pre-switching signal and a control switching signal. Each transition in the control switching signal is preceded by a transition in the pre-switching signal. In response to a transition in the pre-switching signal, the control logic is configured to turn off one of the two switching elements, so that both switching elements are OFF. In response to a transition in the control switching signal, the control logic is configured to turn on the other of the two switching elements. Also disclosed are modules and power supplies including the driver circuit, and an associated method of driving a control terminal of a power transistor.

## Description

### FIELD OF THE INVENTION

This invention relates to circuits and methods for driving power transistors. In particular, it relates to driving a power transistor, such as a MOSFET, in a power supply.

### BACKGROUND OF THE INVENTION

Turning power transistors on and off is a ubiquitous operation in electronic circuits such as power supplies. For example, the power output of a power supply or power converter may be regulated by controlling the duty cycle of one or more power transistors.

It is known to provide a driver circuit for a power transistor such as a power metal-oxide-semiconductor field-effect transistor (power MOSFET). The purpose of the driver circuit is to drive the gate of the MOSFET so that the transistor turns on and turns off reasonably quickly and predictably.

WO 2016/188385 A1 discloses a gallium nitride driver with tuned dead-time. US 2020/0067502 A1 discloses a semiconductor device including a dead-time generation circuit.

### SUMMARY OF THE INVENTION

To increase efficiency while delivering sufficient power to the load, it would be desirable to be able to control accurately the switching of the power transistor(s).

In some cases, a power supply may be controlled by closed loop feedback. In such cases, it is desirable for the power supply to respond quickly to changes in the feedback signal.

Relative timings among multiple components may also be important. In a push-pull configuration, for example, with series-connected high side and low side power transistors, it is important that the two power transistors are never switched on at the same time. Having both transistors switched on simultaneously would allow a shoot-through current to flow. At best, this would be very wasteful of power; at worst, the overcurrent might damage or destroy the power supply. This problem can be avoided by introducing a dead time between one transistor turning off and the other transistor turning on. However, it would be desirable for this dead time to be as short as possible, to improve efficiency.

Unfortunately, it is not trivial to control the switching of power transistors accurately. It always takes some finite, nonzero time to turn on or turn off a transistor, such as a (MOSFET), dependent on effects such as the Miller plateau. The problem may be particularly pronounced for inductive loads and/or large transistors. If the dead time is controlled by a "blind" delay time (that is, without measurement and feedback of the switch states) then it may be necessary to be cautious and implement a delay time that is excessively long in some circumstances.

The inventor has identified a need for improved driver circuits.

A driver circuit is provided for driving a control terminal of a power transistor. The driver circuit includes a final driver stage with two switching elements. These two switching elements are coupled in series through an output node, which is configured to be coupled to the control terminal of the power transistor. Control logic of the driver circuit is configured to control the switching of the two switching elements so that at most one of the two switching elements is ON at any time. The control logic is configured to receive a pre-switching signal and a control switching signal. Each transition in the control switching signal is preceded by a transition in the pre-switching signal. In response to a transition in the pre-switching signal, the control logic is configured to turn off one of the two switching elements, so that both switching elements are OFF. In response to a transition in the control switching signal, the control logic is configured to turn on the other of the two switching elements. Also disclosed are modules and power supplies including the driver circuit, and an associated method of driving a control terminal of a power transistor.

According to one aspect, there is provided a driver circuit for a control terminal of a power transistor, the driver circuit comprising:
a final driver stage comprising two switching elements, the two switching elements comprising a high side switching element and a low side switching element coupled in series through an output node that is configured to be coupled to the control terminal of the power transistor; and
control logic configured to control the switching of the high side switching element and the low side switching element such that at most one of the two switching elements is switched on at any time,
wherein the control logic is configured to receive a pre-switching signal and a control switching signal (optionally wherein each transition in the control switching signal is preceded by a transition in the pre-switching signal),
wherein the control logic is configured to, responsive to a change of state of the pre-switching signal, turn off one of the two switching elements so that both switching elements are switched off, and
wherein the control logic is configured to, responsive to a change of state of the control switching signal, turn on the other of the two switching elements.

In this way, the pre-switching signal may prepare the driver circuit so that it is ready to drive the control terminal (e.g., gate) of the power transistor to the opposite rail when the control switching signal changes state. The pre-switching signal and the control signal may be generated such that there is a short interval between the turn-off of one switching element and the turn-on of the other. During this short interval, the control terminal (e.g., gate) of the power transistor may in principle be floating. However, it may be held in substantially its previous state (e.g., at its previous voltage) by a capacitance at the control terminal. (The capacitance may be, for example, a parasitic capacitance of the control terminal.)

The use of the pre-switching signal can help to minimise a latency associated with turn-on of the other switching element when the control switching signal changes state. Without the use of the pre-switching signal, the control logic would be required to first turn off one switching element and then turn on the other switching element, after the change of state of the control switching signal. In contrast, the driver circuit summarised above can perform one of these two actions prior to the change of state of the control switching signal. The advance turn-off of one switching element may be advantageous, because turning off a switching element may be a slower process than turning it on.

The driver may further comprise a first driver stage, the first driver stage comprising four switching elements, comprising: a first pair of switching elements configured to drive a control terminal of the high side switching element in the final driver stage; and second pair of switching elements configured to drive a control terminal of the low side switching element in the final driver stage, wherein the control logic is configured to, responsive to the change of state of the pre-switching signal: turn off two of the four switching elements so that all of the four switching elements are switched off; and then turn on one of the four switching elements, to thereby turn off said one of the two switching elements in the final driver stage.

The control logic may ensure that only one switching element of each pair of switching elements in the first driver stage is switched on at any time.

The control logic may be configured to, responsive to the change of state of the control switching signal, turn on one of the four switching elements of the first driver stage, to thereby turn on the other of the two switching elements in the final driver stage.

The control logic optionally comprises: a first feedback path from a control terminal of one of the first pair of switching elements, to control the second pair of switching elements; and a second feedback path from a control terminal of one of the second pair of switching elements, to control the first pair of switching elements. Each feedback path may include an inverter.

The control logic may comprise: a first NAND gate configured to control a control terminal of one of the first pair of switching elements; and a first NOR gate configured to control a control terminal of the other of the first pair of switching elements.

The first NAND gate may be configured to receive a first input based on the pre-switching signal. (In particular, the first input may be an inverted version of the pre-switching signal.) The first NAND gate may be configured to receive a second input from the second feedback path.

The first NOR gate may be configured to receive a first input based on the pre-switching signal. (In particular, the first input may be an inverted version of the pre-switching signal.) The first NOR gate may be configured to receive a second input from the second feedback path. The first NOR gate may be configured to receive a third input based on the control switching signal. (In particular, the third input may be an inverted version of the control switching signal.)

The control logic optionally comprises: a second NAND gate configured to control a control terminal of one of the second pair of switching elements; and a second NOR gate configured to control a control terminal of the other of the second pair of switching elements.

The second NAND gate may be configured to receive a first input based on the pre-switching signal. (In particular, the first input may be an inverted version of the pre-switching signal.) The second NAND gate may be configured to receive a second input from the first feedback path. The second NAND gate may be configured to receive a third input based on the control switching signal. (In particular, the third input may be an inverted version of the control switching signal.)

The second NOR gate may be configured to receive a first input based on the pre-switching signal. (In particular, the first input may be an inverted version of the pre-switching signal.) The second NOR gate may be configured to receive a second input from the first feedback path.

The driver circuit may further comprise four drivers, wherein each driver is configured to drive a respective one of the four switching elements of the first driver stage. Each driver may comprise an inverter chain, in particular a scaled inverter chain.

Optionally: the first pair of switching elements comprises a first PMOS transistor and a first NMOS transistor; and/or the second pair of switching elements comprises a second PMOS transistor and a second NMOS transistor.

The first NAND gate mentioned above may control the first PMOS transistor; the first NOR gate may control the first NMOS transistor. The second NAND gate may control the second PMOS transistor; the second NOR gate may control the second NMOS transistor.

The high side switching element may be a PMOS transistor and the low side switching element may be an NMOS transistor.

The high side switching element may be coupled to the output node through a resistor. The resistor may assist in limiting the charge of the control terminal (e.g., gate) of the power transistor, in order to limit the slew rate of the output. This may help to avoid a parasitic induced ON state of an opposing switching element in a power electronic circuit. It may also help to improve electromagnetic compatibility.

The low side switching element may be connected directly to the output node (that is, without a limiting resistor). This may help to increase the speed with which the power transistor can turn off.

The driver circuit may further comprise a switch status output, configured to provide a status signal based on a voltage at the output node. The status signal may be generated by a Schmitt trigger, whose input is coupled to the output node (that is, to the control terminal of the power transistor).

Also provided is a module comprising:
a driver circuit as summarised above; and
a power transistor, having a control terminal coupled to the output node of the driver circuit.

The power transistor may be a MOSFET - for example, an NMOS FET. The module may have terminals for: a supply voltage; the pre-switching signal; the control switching signal; the switch status output. It may further have terminals for carrying a current switched by the power transistor (for example, a drain terminal and a source terminal, when the power transistor is a MOSFET).

The driver circuit and the power transistor may be packaged together to form the module.

Also provided is a power supply comprising:
a driver circuit as summarised above;
a controller, configured to generate a pre-switching signal and a control switching signal for the driver circuit; and
a power transistor, having a control terminal coupled to the output node of the driver circuit.

The power transistor may be coupled to an inductive load.

Further provided is a power supply comprising:
a first driver circuit as summarised above;
a first power transistor, having a control terminal coupled to the output node of the first driver circuit;
a second driver circuit as summarised above;
a second power transistor, having a control terminal coupled to the output node of the second driver circuit;
a controller, configured to generate a pre-switching signal and a control switching signal; and
further control logic, configured to generate based on the pre-switching signal:
   a first pre-switching signal for the first driver circuit, and
   a second pre-switching signal for the second driver circuit,
wherein the further control logic is configured to generate based on the control switching signal:
   a first control switching signal for the first driver circuit, and
   a second control switching signal for the second driver circuit.

The further control logic may be configured to generate the first control switching signal based in part on a switch status output of the second driver circuit, and to generate the second control switching signal based in part on a switch status output of the first driver circuit.

Also provided is a method for driving a control terminal of a power transistor, the method comprising:
receiving a pre-switching signal and a control switching signal (optionally wherein each transition in the control switching signal is preceded by a transition in the pre-switching signal);
providing a final driver stage comprising two switching elements, the two switching elements comprising a high side switching element and a low side switching element coupled in series through an output node that is coupled to the control terminal of the power transistor;
responsive to a change of state of the pre-switching signal, turning off one of the two switching elements so that both of the switching elements are switched off, and
responsive to a change of state of the control switching signal, turning on the other of the two switching elements.

The method may further comprise: providing four switching elements, comprising: a first pair of switching elements configured to drive a control terminal of the high side switching element; and a second pair of switching elements configured to drive a control terminal of the low side switching element, and responsive to the change of state of the pre-switching signal: turning off two of the four switching elements so that all of the four switching elements are switched off; and then turning on one of the four switching elements, to thereby turn off said one of the two switching elements of the final driver stage.

### BRIEF DESCRIPTION OF THE DRAWINGS

The invention will now be described by way of example with reference to the accompanying drawings, in which:
Fig. 1 is a circuit diagram showing a power transistor module containing a driver circuit according to an example;
Fig. 2 is a timing diagram, showing how signals propagate through the circuit of Fig. 1;
Fig. 3 is a circuit diagram showing a push-pull driver for an inductive load, according to an example;
Fig. 4 is a timing diagram for the circuit of Fig. 3;
Fig. 5A shows an exemplary circuit for generating a pre-switching signal (and a control switching signal) for use in a driver circuit according to an example; and
Fig. 5B is a plot illustrating how the circuit of Fig. 5A can generate the pre-switching signal (and control switching signal), according to an example.

It should be noted that these figures are diagrammatic and not drawn to scale. Relative dimensions and proportions of parts of these figures have been shown exaggerated or reduced in size, for the sake of clarity and convenience in the drawings.

### DETAILED DESCRIPTION

For clarity, the phrases "switched on" and "switched off" will be used herein to denote the state (ON or OFF) of a switching element. The process of changing the state of a switching element will be described using the verb "turn" - as in "turn on" and "turn off". It is hoped that this will avoid any confusion as to whether a state or a state-transition is being referred to, in each instance.

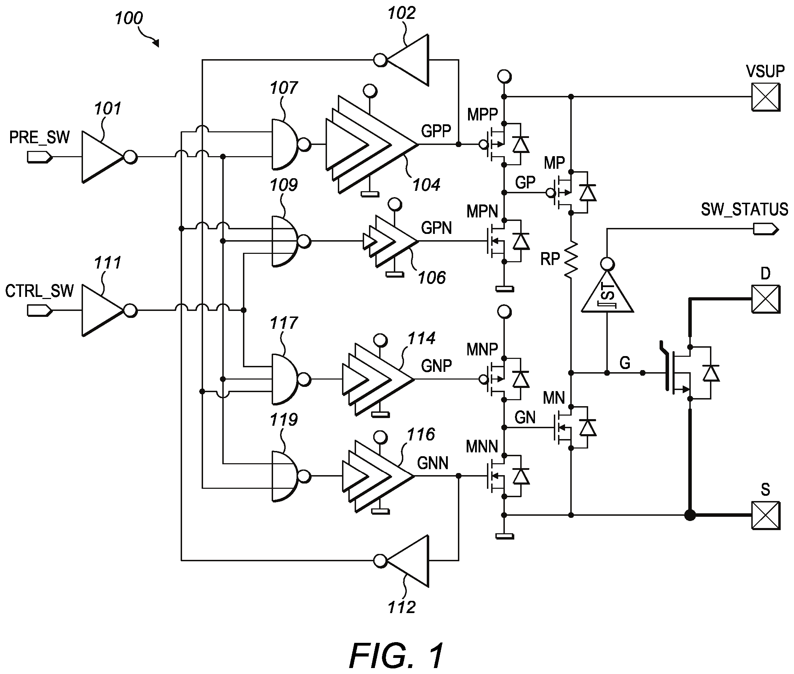

Fig. 1 shows a power transistor module 100 according to an example. The module includes a power transistor MSW and a driver circuit for the power transistor. In the present example, the power transistor MSW is provided in the same package as the driver circuit. This may be advantageous, but it should be understood that the scope of the present disclosure is not limited to such arrangements.

The module has six pins or leads for external connections. There are two control inputs, for a pre-switching signal PRE_SW and a control switching signal CTRL_SW, respectively. There is a pin for the supply voltage VSUP, and there are pins for the drain D and source S, respectively, of the power transistor MSW. It is assumed that the source S of the power transistor is connected to the local ground of this driver circuit supply domain. A further pin provides a switch status output signal SW_STATUS, indicating the status (off or on) of the power transistor MSW.

The driver circuit has two driver stages. The second (and final) driver stage comprises a high side switching element MP and a low side switching element MN. As with all of the switching elements in the present example, these switching elements are MOS transistors (MOSFETS). The high side switching element MP is a PMOS transistor MP and the low side switching element MN is an NMOS transistor. The drain of the high side switching element MP is connected to the supply rail VSUP. The source of the high side switching element MP is connected in series with the drain of the low side switching element MN, via a resistor RP. The source of the low side switching element MN is connected to the local ground. The drain of the low side switching element MN forms the output node of the driver circuit. It is connected to the gate G of the power transistor MSW.

With this configuration, the gate G of the power transistor MSW is driven to the supply voltage when the high side switching element MP is switched on (and the low side switching element MN is switched off). The gate G is driven to ground when the low side switching element MN is switched on (and the high side switching element MP is switched off).

A Schmitt trigger ST is also connected to the gate G of the power transistor MSW. This provides the switch status output signal SW_STATUS.

The first driver stage drives the second (final) driver stage. The first driver stage is formed by four switching elements. A first pair of switching elements MPP, MPN drives the gate of the high side switching element MP in the final driver stage. A second pair of switching elements MNP, MNN drives the gate of the low side switching element MN in the final driver stage.

In the first pair of switching elements, the PMOS switching element MPP has its drain connected to the supply rail VSUP. The NMOS switching element MPN has its drain connected to the source of the PMOS switching element MPP. This node is also connected to the gate GP of the high side switching element MP in the final driver stage. The source of the NMOS switching element MPN is connected to the local ground.

With this configuration, the gate GP of the high side switching element MP is driven to the supply voltage when the PMOS switching element MPP is switched on. Conversely, it is driven to ground when the NMOS switching element MPN is switched on.

The second pair of switching elements is configured similarly. That is, the PMOS switching element MNP has its drain connected to the supply rail VSUP. The NMOS switching element MNN has its drain connected to the source of the PMOS switching element MPP. This node is also connected to the gate GN of the low side switching element MN in the final driver stage. The source of the NMOS switching element MNN is connected to the local ground. The second pair of switching elements therefore drives the gate GN of the low side switching element MN in the same way that the first pair of switching elements drives the gate GP of the high side switching element MP.

The driver circuit further includes four drivers 104, 106, 114, 116. Each of these is configured to drive the gate of the respective four switching elements MPP, MPN, MNP, MNN in the first driver stage. That is: the driver 104 drives the gate GPP of the PMOS switching element MPP in the first pair of switching elements; the driver 106 drives the gate GPN of the NMOS switching element MPN in the first pair of switching elements. The driver 114 drives the gate GNP of the PMOS switching element MNP in the second pair of switching elements; and the driver 116 drives the gate GNN of the NMOS switching element MNN in the second pair of switching elements. Each driver consists of a scaled inverter chain.

The driver circuit further comprises control logic configured to control the switching elements of the driver circuit, and thereby control the power transistor MSW. The control logic receives two external inputs - the pre-switching signal PRE_SW and the control switching signal CTRL_SW. These input signals are inverted and amplified by inverters 101 and 111, respectively. The control logic further comprises:
- A first NAND gate 107, with its output coupled to the input of the driver 104;
- A first NOR gate 109, with its output coupled to the input of the driver 106;
- A second NAND gate 117, with its output coupled to the input of the driver 114; and
- A second NOR gate 119, with its output coupled to the input of the driver 116.

There are also two feedback inverters 102 and 112. The first feedback inverter 102 provides feedback from the gate GPP of the PMOS switching element MPP of the first pair, to an input of the second NAND gate 117 and an input of the second NOR gate 119. The second feedback inverter 112 provides feedback from the gate GNN of the NMOS switching element MNN of the second pair, to an input of the first NAND gate 107 and an input of the first NOR gate 109.

The first NAND gate 107 receives two inputs: a feedback signal from the second feedback inverter 112; and the (inverted) pre-switching signal PRE_SW.

The first NOR gate 109 receives three inputs: the feedback signal from the second feedback inverter 112; the (inverted) pre-switching signal PRE_SW; and the (inverted) control switching signal CTRL_SW.

The second NAND gate receives three inputs: the feedback signal from the first feedback inverter 102; the (inverted) pre-switching signal PRE_SW; and the (inverted) control switching signal CTRL_SW,

The second NOR gate receives two inputs: the feedback signal from the first feedback inverter 102; and the (inverted) pre-switching signal PRE_SW.

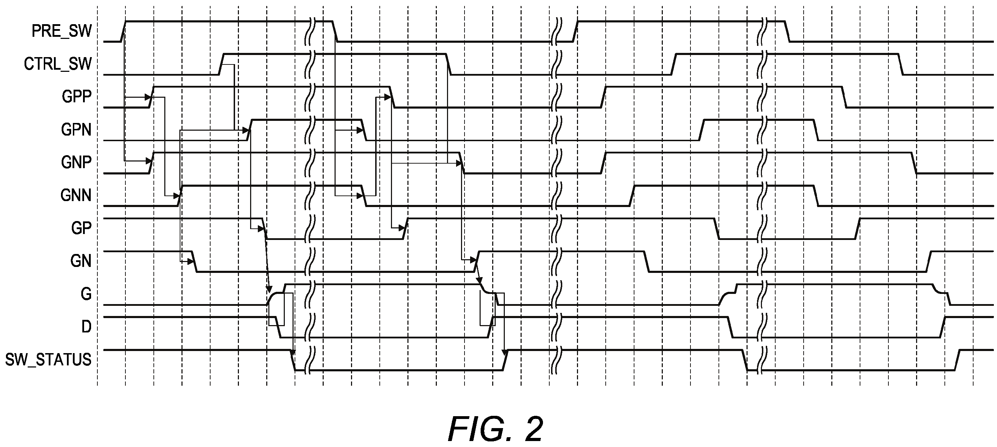

The operation of the driver circuit of Fig. 1 will now be explained with reference to the signal-timing shown in Fig. 2. To begin with (starting from the far left in Fig. 2), the pre-switching signal and the control switching signal are both low. The gates of all of the switching elements MPP, MPN, MNP, and MNN in the first driver stage are low. This means that the PMOS switching elements MPP and MNP are switched on. In turn, this means that the gate GP of the high side switching element MP in the final driver stage is high, and consequently this switching element MP is switched off. The gate GN of the low side switching element MN is high; accordingly, the switching element MN is switched on and the gate G of the power transistor MSW is pulled to ground (low). The power transistor (which is an NMOS transistor, in this example) is therefore switched off, and its drain voltage D is high. The switch status signal, which is inverted with respect to the voltage at the gate G, is high.

A short time before the control switching signal CTRL_SW switches to high, the pre-switching signal PRE_SW switches to high. This immediately changes the outputs of the first and second NAND gates 107 and 117, such that the gates GPP and GNP of the switching elements MPP and MNP in the first driver stage are driven high by their respective drivers 104 and 114. This turns off these two PMOS switching elements. At this point, all four transistors in the first driver stage are switched off, and the gates of the switching elements in the final driver stage are (briefly) floating. However, the feedback path from the gate GPP of switching element MPP to the second NOR gate 119 then causes the output of this gate to change, causing the gate GNN of the switching element MNN to transition to high. This turns on the switching element MNN, which pulls the gate GN of the low side switching element MN to ground. This turns off the low side switching element MN, leaving the gate G of the power transistor MSW floating. The gate G however holds its voltage, due to parasitic capacitance.

The driver circuit is now ready to respond quickly when there is a transition in the control switching signal. Were it not for the pre-switching signal, the driver circuit would need to go through the necessary transitions to turn off the low side switching element MN after receipt of the transition on the control switching signal. This need has been avoided, by the use of the pre-switching signal to prepare the driver circuit for the remaining transitions.

Continuing the analysis of the timing diagram of Fig. 2, the next event is the transition of the control switching signal CTRL_SW from low to high. This quickly causes the gate GPN of the NMOS switching element MPN to go high, by changing the output of the first NOR gate 109. This turns on the switching element MPN, pulling to ground the gate GP of the high side (PMOS) switching element MP. This turns on the high side switching element MP, which begins to pull up the voltage at the gate G of the power transistor MSW. As the power transistor MSW turns on, its drain-source voltage drops. Eventually, after the drain voltage has dropped fully, the gate voltage crosses the Miller plateau and completes its rise to the high state. The power transistor is now switched on. This is reflected by the switch status signal produced by the Schmitt trigger ST, which goes from high to low. The Schmitt trigger is configured so that the switch status signal does not change until after the gate voltage has risen above the Miller plateau.

The power transistor will remain switched on for a period of time that is long compared with the sequence of transitions described above. When the time comes to turn off the power transistor, the control circuit will again use the pre-switching signal to prepare the driver circuit for fast switching of the power transistor. This will now be described, continuing the example in Fig. 2.

The preparations begin when the pre-switching signal goes from high to low. This immediately propagates through the first NOR gate 109 and second NOR gate 119, changing their output from high to low. This signal propagates through the respective drivers 106 and 116, changing the gates GPN and GNN of the respective switching elements MPN and MNN to low. This turns off the switching elements MPN and MNN, such that all four switching elements in the first driver stage are now switched off. The gates GP and GN of the switching elements in the final driver stage are therefore briefly floating. However, the change of state at the gate GNN is fed back via the second feedback inverter 112 to the first NAND gate 107. This changes its output from high to low in response. The low output from the first NAND gate 107 propagates to the gate GPP of the switching element MPP, via the respective driver 104. This causes the switching element MPP to turn on, thereby pulling high the gate GP of the high side switching element MP in the final driver stage. The high voltage at the gate GP causes the high side switching element MP to turn off. The gate of the power transistor MSW is now floating, since both of the switching elements of the final driver stage are switched off. The driver circuit is now ready to respond rapidly to the impending transition in the control switching signal.

When the control switching signal CTRL_SW now switches from high to low, the transition propagates immediately through the second NAND gate 117 and the corresponding driver 114, changing the gate GNP of the switching element MNP from high to low. This turns on the switching element MNP, causing the gate GN of the low side switching element MN in the final driver stage to be pulled high. This turns on the switching element MN, which begins to pull the gate G of the power transistor MSW down towards ground. As the voltage at the gate G crosses the Miller plateau, the voltage at the drain D rises. Finally, when the drain has reached its steady-state high-voltage, the gate G completes its transition to its steady-state low voltage. The power transistor MSW is now switched off. This is reflected in the switch status signal SW_STATUS produced by the Schmitt trigger ST.

The power transistor will remain switched off for a relatively long period of time (compared with the sequence of transitions needed to turn it off, as described above). The sequences of operations described above are then repeated over time, to turn on and off the power transistor continually, in accordance with the control switching signal and the (leading) pre-switching signal. In each case, the pre-switching signal is used to disable the previously active transistor in the final driver stage, thereby making the gate G of the power transistor undriven. As mentioned above, the gate G is floating in this state. Accordingly, excessive delay between the transition in the pre-switching signal and the transition in the control switching signal should be avoided. If the gate G is floating for too long, leakage currents may begin to cause voltage changes. This can be addressed by appropriate control of the time interval between the pre-switching signal and the control switching signal. As soon as the control switching signal changes state, the gate G of the power transistor MSW is forced to the opposite rail by the relevant switching element in the final switching stage, and the power transistor MSW toggles state accordingly.

It should be noted that the control circuit ensures that no two transistors of any series connected pair are switched on at the same time. In other words, there is an appropriate (but short) dead time between turning off one transistor of a series connected pair and turning on the other transistor of the pair. This is true for all of the driver stages.

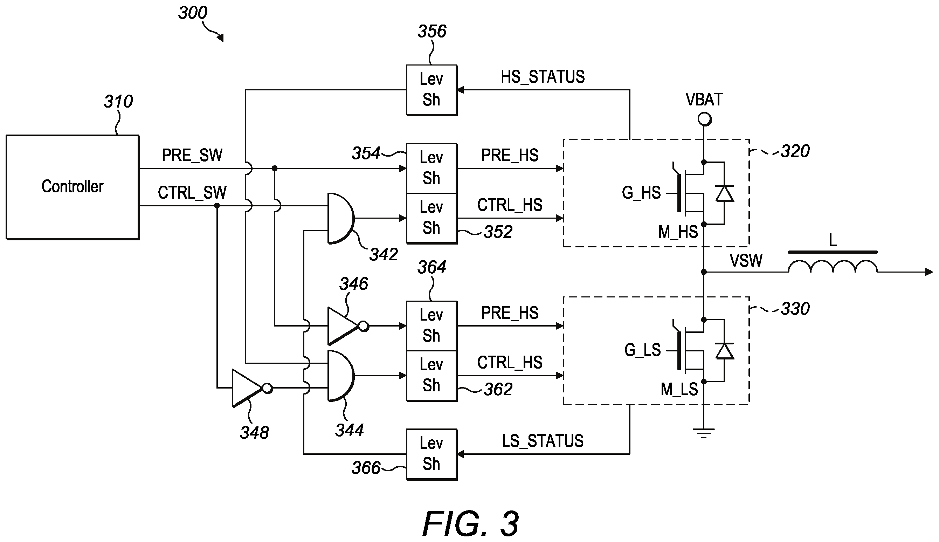

Fig. 3 shows a push-pull power supply 300 for an inductive load, according to an example. It includes two instances 320, 330 of the module 100 of Fig. 1. The first module 320 includes a first power transistor M_HS, which operates as a high side switch in the power supply. The second module 330 includes a second power transistor M_LS, which operates as a low side switch in the power supply. The source of the high side transistor M_HS and the drain of the low side transistor M_LS are coupled to the inductive load L at a switching node VSW. The drain of the high side transistor M_HS is connected to the supply voltage. The source of the low side transistor M_LS is connected to the system ground. The switching node VSW is a local ground for the first (high side) module 320. The system ground is also a local ground for the second (low side) module 330.

A controller 310 provides a master pre-switching signal and a master control signal. These are converted to pre-switching and control signals for the first and second modules by some further control logic, and two pairs of level shifters 352-354 and 362-364. The switch status signal from each module 320, 330 is fed back to the further control logic via additional level shifters 356 and 366, respectively. The level shifters are supply-domain crossing circuits. They are not needed in all examples. For instance, they would not be required in a boost converter topology.

The further control logic comprises AND gates 342 and 344, and inverters 346 and 348. The first pre-switching signal PRE_HS for the first module 320 is generated directly from the master pre-switching signal, via the level shifter 354. To generate the second pre-switching signal PRE_LS for the second module 330, the master pre-switching signal is inverted by the first inverter 346. This inverted version is passed to the second module 330 via the level shifter 364.

The output of the AND gate 342 is connected to the level shifter 352. This provides the first control switching signal CTRL_HS for the first module 320. To generate this signal, the AND gate takes two inputs: the master control switching signal CTRL_SW; and the fed back status signal from the second module 330 (passed via the level shifter 366).

The output of the AND gate 344 is connected to the level shifter 362. This provides the second control switching signal CTRL_LS for the second module 330. To generate this signal, the AND gate takes two inputs: an inverted version of the master control switching signal CTRL_SW, which is generated by the second inverter 348; and the fed back status signal from the first module 320 (passed via the level shifter 356).

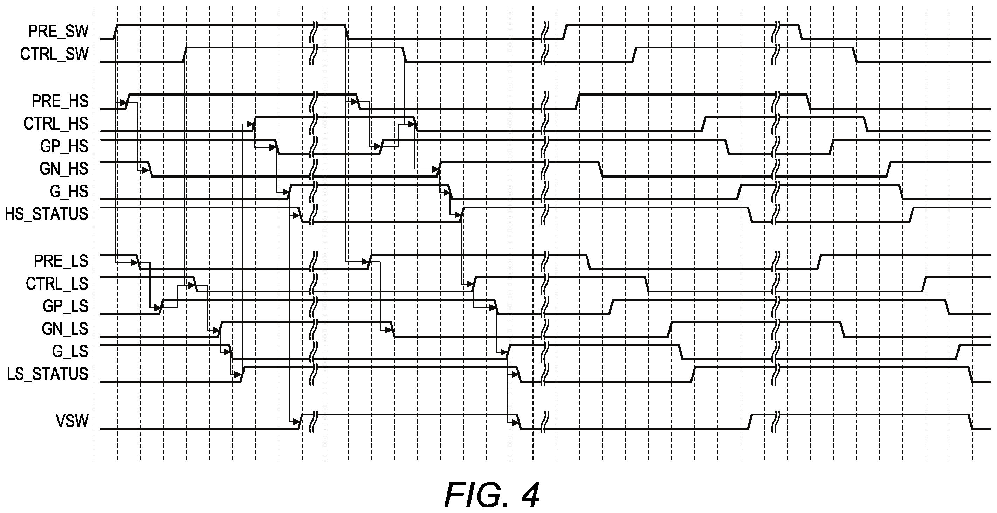

The operation of the power supply will now be described with reference to the timing diagram of Fig. 4. To begin with (starting at the left-hand side in Fig. 4), both the master pre-switching signal and the master control switching signal are low. The gate G_HS of the high side power transistor M_HS is low, meaning that this transistor is switched off. The gate G_LS of the low side power transistor M_LS is high, meaning that this transistor is switched on. In the final driver stage of the first module 320, the gate GP of the high side switching element MP is high. This is indicated by the signal GP_HS in Fig. 4. The gate GN of the low side switching element MN in the first module 320 is also high. This is indicated by the signal GN_HS in Fig. 4. Meanwhile, in the final driver stage of the second module 330, the gate GP of the high side switching element MP and the gate GN of the low side switching element MN are both low. These signals are indicated as GP_LS and GN_LS, respectively, in Fig. 4.

When the master pre-switching signal PRE_SW transitions from low to high, this is reflected almost immediately in the pre-switching signal PRE_HS for the first module 320. With a slightly longer delay (due to the inverter 346), it is also reflected in a high-to-low transition in the pre-switching signal PRE_LS for the second module 330. The transition in the pre-switching signal PRE_HS triggers a transition at the gate GN_HS from high to low. Consequently, the switching element MN in the first module 320 is turned off. Meanwhile, in the second module 330, the transition of the pre-switching signal PRE_LS to low triggers a transition at the gate GP_LS from low to high. Consequently, the switching element MP in the second module 330 is turned off. Both driver circuits are now ready for transitions in their respective control switching signals.

When the master control switching signal CTRL_SW transitions from low to high, the output of the AND gate 344 responds essentially immediately (subject to some minimum propagation delay through the second inverter 348 and the AND gate 344). The fed back status signal HS_STATUS is high at this moment; therefore, the transition from high to low at the other input of the AND gate causes the output of the AND gate to go low. As seen in the timing diagram, this causes the second control switching signal CTRL_LS to transition from high to low. In response, the gate GN_LS of the switching element MN in the second module goes high, turning on this switching element MN, and driving the gate G_LS of the low side power transistor M_LS towards ground. This turns off the low side power transistor M_LS, as reflected in the status signal LS_STATUS output by the second module 330. Through the feedback to the input of the AND gate 342, the transition in the status signal LS_STATUS from low to high then causes the control switching signal CTRL_HS for the first module 320 to transition from low to high. In response, the gate GP_HS of the switching element MP in the first module 320 transitions from high to low, turning on the switching element MP, pulling up the gate G of the high side power transistor M_HS, and turning on this power transistor M_HS. The voltage at the switching node VSW goes high, and the status signal from the first module 320 transitions from high to low.

This state is maintained for a time interval that depends on the duty cycle, set by the controller. This time interval is relatively long compared with the time taken for the switching transitions described above.

Shortly before the high to low transition of the master control switching signal, the controller 310 causes the master pre-switching signal PRE_SW to transition from high to low. This is reflected almost immediately in a high to low transition in the pre-switching signal PRE_HS for the first module 320, and - with a slight delay - a low to high transition in the pre-switching signal PRE_LS for the second module 330. The driver circuit in the first module 320 responds to the master pre-switching signal PRE_SW by turning off the switching element MP in its final driver stage. The driver circuit in the second module 330 responds to the master pre-switching signal PRE_SW by turning off the switching element MN in its final driver stage.

When the master control switching signal CTRL_SW transitions from high to low, the control switching signal CTRL_HS for the first module responds essentially immediately, subject only to the latency of the AND gate 342 (and the level shifter 352). There is not yet any change in the control switching signal CTRL_LS for the second module 330, because the fed back status signal HS_STATUS at one input of the AND gate 344 is low.

In response to the transition of its control switching signal CTRL_HS from high to low, the driver circuit in the first module 320 turns on the switching element MN in its final driver stage, thereby initiating the turn-off of the associated power transistor M_HS. Once the power transistor M_HS has been turned off, this is reflected in the status signal HS_STATUS, which transitions from low to high. This is fed back to the AND gate 344, which responds by generating a low to high transition in the control switching signal CTRL_LS for the second module 330.

In response to the transition of its control switching signal CTRL_LS from low to high, the driver circuit in the second module 330 turns on the switching element MP in its final driver stage, thereby initiating the turn-on of the associated power transistor M_LS. When the power transistor M_LS is switched on, this is reflected in the status signal LS_STATUS from the second module 330, which goes low, and in the voltage at the switching node VSW, which also goes low.

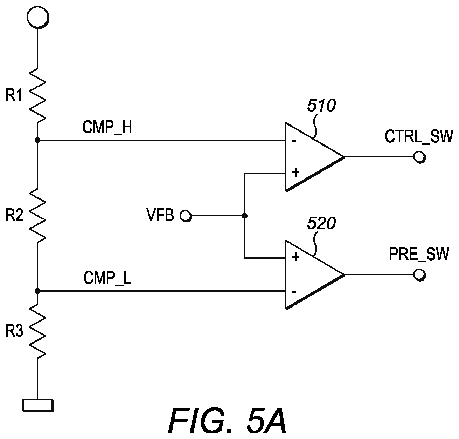

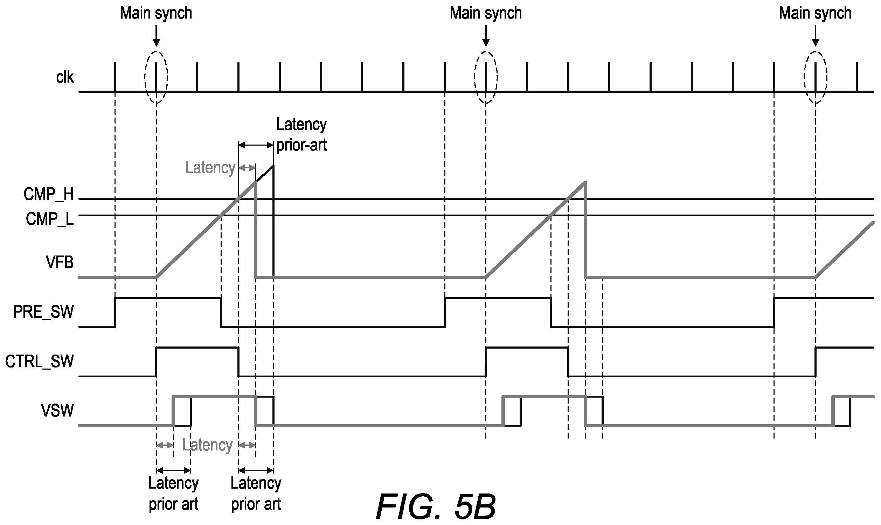

Fig. 5A shows one circuit which may be used by the controller 310 to generate an appropriate pre-switching signal and control switching signal. This uses a voltage divider formed of three resistors R1, R2, and R3 connected in series. A first reference voltage CMP_H is created at the node between R1 and R2. A second, lower reference voltage CMP_L is created at the node between R2 and R3. The reference voltages are fed to the inverting inputs of respective comparators 510 and 520. At the noninverting input of each comparator, a feedback signal VFB is provided. This is a sawtooth signal whose slope is related to the power drawn by the load. This is shown in Fig. 5B.

The uppermost plot in Fig. 5B is a system clock CLK with regular periodic pulses. The rising edge of the master control switching signal CTRL_SW is triggered by a main sync pulse (every 8^{th} pulse of the clock). The same event also triggers the start of the rising ramp of the sawtooth function VFB. The rising edge of the master pre-switching signal is triggered by the pulse before the main sync pulse.

Each time the voltage VFB reaches CMP_H, the comparator 510 generates a high-to-low (falling edge) transition in the control switching signal. Each time the voltage VFB reaches CMP_L, the comparator 520 generates a transition in the pre-switching signal. As CMP_L is less than CMP_H, the falling edge of the pre-switching signal always occurs before the falling edge of the control switching signal. The exact delay depends on the relative values of the resistance (as well as on the slope of the sawtooth). In particular, relatively smaller values of R2 will produce relatively shorter delays between the falling edge of the pre-switching signal and the falling edge of the control switching signal.

Fig. 5B also shows the voltage at the switching node VSW. This goes high a certain time after the rising edge of the control switching signal CTRL_SW, and it goes low a certain time after the falling edge of the control switching signal. These time delays define the latency of the driver circuit. The rising ramp of the sawtooth function is terminated and reset when the voltage at the switching node VSW goes from high to low.

For comparison, plots are shown both for the example of Fig. 3 and for a notional comparative example (labelled "prior art"). The comparative example does not use the pre-switching signal PRE_SW. Consequently, it has more actions to complete in response to the falling edge of the control switching signal CTRL_SW. As can be seen, the present example reduces the latency and thereby increases the responsiveness of the power transistor to the control loop. Additionally, the dead time is controlled by the local feedback paths within the driver circuits and is therefore minimized (taking into account variations and shifts in parameters such as temperature, transistor-speed, and line/load conditions). This contributes to a reduction in losses in the power supply.

It should be noted that the above-mentioned embodiments illustrate rather than limit the invention, and that those skilled in the art will be able to design many alternative embodiments without departing from the scope of the appended claims.

In the examples above, the switching elements and the power transistors were MOSFETs. This is of course not essential. Likewise, as already mentioned above, it is not essential that each power transistor MSW is integrated into a module with its driver circuit. The power transistor could be provided externally to a module containing the driver circuit, for example.

The example of Figs. 5A-5B represents just one way to generate a suitable pre-switching signal and control signal. Those skilled in the art will be able to devise other suitable ways, based on the foregoing disclosure.

In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The embodiments may be implemented by means of hardware comprising several distinct elements. In a device claim enumerating several means, several of these means may be embodied by one and the same item of hardware. The mere fact that certain measures are recited in mutually different dependent claims does not indicate that a combination of these measures cannot be used to advantage. Furthermore in the appended claims lists comprising "at least one of: A; B; and C" should be interpreted as (A and/or B) and/or C.

Embodiments as discussed herein may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre-stored design modules. Once the design for a semiconductor circuit has been completed, the resultant design, in a standardized electronic format (e.g., Opus, GDSII, or the like) may be transmitted to a semiconductor fabrication facility or "fab" for fabrication.

## Claims

1. A driver circuit for a control terminal of a power transistor, the driver circuit comprising:
a final driver stage comprising two switching elements, the two switching elements comprising a high side switching element (MP) and a low side switching element (MN) coupled in series through an output node that is configured to be coupled to the control terminal of the power transistor; and
control logic configured to control the switching of the high side switching element and the low side switching element such that at most one of the two switching elements is switched on at any time,
wherein the control logic is configured to receive a pre-switching signal and a control switching signal, wherein each transition in the control switching signal is preceded by a transition in the pre-switching signal,
wherein the control logic is configured to, responsive to a change of state of the pre-switching signal, turn off one of the two switching elements so that both switching elements are switched off, and
wherein the control logic is configured to, responsive to a change of state of the control switching signal, turn on the other of the two switching elements.

2. The driver circuit of claim 1, further comprising a first driver stage, the first driver stage comprising four switching elements, comprising:
a first pair of switching elements (MPP, MPN) configured to drive a control terminal of the high side switching element (MP) in the final driver stage; and
a second pair of switching elements (MNP, MNN) configured to drive a control terminal of the low side switching element (MN) in the final driver stage,
wherein the control logic is configured to, responsive to the change of state of the pre-switching signal:
turn off two of the four switching elements so that all of the four switching elements are switched off; and then
turn on one of the four switching elements, to thereby turn off said one of the two switching elements in the final driver stage.

3. The driver circuit of claim 2, wherein the control logic is configured to, responsive to the change of state of the control switching signal, turn on one of the four switching elements of the first driver stage, to thereby turn on the other of the two switching elements in the final driver stage.

4. The driver circuit of claim 2 or claim 3, wherein the control logic comprises:
a first feedback path from a control terminal of one of the first pair of switching elements, to control the second pair of switching elements; and
a second feedback path from a control terminal of one of the second pair of switching elements, to control the first pair of switching elements,
wherein each feedback path optionally includes an inverter (102, 112).

5. The driver circuit of any one of claims 2 to 4, wherein the control logic comprises:
a first NAND gate (107) configured to control a control terminal of one (MPP) of the first pair of switching elements; and
a first NOR gate (109) configured to control a control terminal of the other (MPN) of the first pair of switching elements.

6. The driver circuit of any one of claims 2 to 5, wherein the control logic comprises:
a second NAND gate (117) configured to control a control terminal of one (MNP) of the second pair of switching elements; and
a second NOR gate (119) configured to control a control terminal of the other (MNN) of the second pair of switching elements.

7. The driver circuit of any one of claims 2 to 6, further comprising four drivers (104, 106, 114, 116), wherein each driver is configured to drive a respective one of the four switching elements (MPP, MPN, MNP, MNN) of the first driver stage.

8. The driver circuit of any one of claims 2 to 7, wherein:
the first pair of switching elements (MPP, MPN) comprises a first PMOS transistor and a first NMOS transistor; and
the second pair of switching elements (MNP, MNN) comprises a second PMOS transistor and a second NMOS transistor.

9. The driver circuit of any one of the preceding claims, wherein the high side switching element (MP) is a PMOS transistor and the low side switching element (MN) is an NMOS transistor.

10. The driver circuit of any one of the preceding claims, wherein the high side switching element (MP) is coupled to the output node through a resistor (RP).

11. The driver circuit of any one of the preceding claims, further comprising a switch status output, configured to provide a status signal based on a voltage at the output node.

12. A module (100) comprising:
a driver circuit according to any one of the preceding claims; and
a power transistor (MSW), having a control terminal coupled to the output node of the driver circuit.

13. A power supply comprising:
a driver circuit according to any one of claims 1 to 11;
a controller (310), configured to generate the pre-switching signal and the control switching signal for the driver circuit; and
a power transistor (MSW), having a control terminal coupled to the output node of the driver circuit.

14. A power supply (300) comprising:
a first driver circuit according to any one of claims 1 to 11;
a first power transistor (M_HS), having a control terminal coupled to the output node of the first driver circuit;
a second driver circuit according to any one of claims 1 to 11;
a second power transistor (M_LS), having a control terminal coupled to the output node of the second driver circuit;
a controller (310), configured to generate a pre-switching signal and a control switching signal; and
further control logic (342, 344, 346), configured to generate based on the pre-switching signal:
a first pre-switching signal for the first driver circuit, and
a second pre-switching signal for the second driver circuit,
wherein the further control logic is configured to generate based on the control switching signal:
a first control switching signal for the first driver circuit, and
a second control switching signal for the second driver circuit.

15. A method for driving a control terminal of a power transistor, the method comprising:
receiving a pre-switching signal and a control switching signal, wherein each transition in the control switching signal is preceded by a transition in the pre-switching signal;
providing a final driver stage comprising two switching elements, the two switching elements comprising a high side switching element (MP) and a low side switching element (MN) coupled in series through an output node that is coupled to the control terminal of the power transistor;
responsive to a change of state of the pre-switching signal, turning off one of the two switching elements so that both of the switching elements are switched off, and
responsive to a change of state of the control switching signal, turning on the other of the two switching elements.
